# EUROPÄISCHE PATENTSCHRIFT

(11) **EP 3 956 923 B1**
(45) Veröffentlichungstag und Bekanntmachung des Hinweises auf die Patenterteilung: **25.12.2024**
(21) Anmeldenummer: 20717818.7
(22) Anmeldetag: 02.04.2020
(51) Int. Cl.: H01L 21/443, H01L 21/285, H01L 21/203, H01L 21/265

(54) **HERSTELLEN EINES OHMSCHEN KONTAKTS SOWIE ELEKTRONISCHES BAUELEMENT MIT OHMSCHEM KONTAKT**
PRODUCING AN OHMIC CONTACT, AND ELECTRONIC COMPONENT WITH OHMIC CONTACT
FABRICATION D'UN CONTACT OHMIQUE AINSI QUE COMPOSANT ÉLECTRONIQUE COMPRENANT UN CONTACT OHMIQUE

(30) Priorität: 15.04.2019 DE 102019205376
(43) Veröffentlichungstag der Anmeldung: 23.02.2022
(73) Patentinhaber: Forschungszentrum Jülich GmbH, 52425 Jülich (DE)
(72) Erfinder: PAWLIS, Alexander, 52477 Alsdorf (DE); JANßEN, Johanna, 52074 Aachen (DE); BENNEMANN, Benjamin, 52428 Jülich (DE); KRAUSE, Christoph, 52428 Jülich (DE)
(74) Vertreter: Gille Hrabal Partnerschaftsgesellschaft mbB Patentanwälte
(86) Internationale Anmeldenummer: PCT/EP2020/059394
(87) Internationale Veröffentlichungsnummer: WO 2020/212154

(56) Entgegenhaltungen:
- EP-A1- 0 674 347
- EP-A2- 0 766 297
- EP-A2- 1 150 360
- JP-A- H0 955 365
- US-A1- 2018 096 885
- HANSON R ET AL: "Spins in few-electron quantum dots", ARXIV.ORG, CORNELL UNIVERSITY LIBRARY, 201 OLIN LIBRARY CORNELL UNIVERSITY ITHACA, NY 14853, 16 October 2006 (2006-10-16), XP080256043, DOI: 10.1103/REVMODPHYS.79.1217
- HUGHES W C ET AL: "Surface preparation of ZnSe substrates for MBE growth of II-VI light emitters", JOURNAL OF CRYSTAL GROWTH, ELSEVIER, AMSTERDAM, NL, vol. 175-176, no. 3001, 1 May 1997 (1997-05-01), pages 546 - 551, XP004091353, ISSN: 0022-0248, DOI: 10.1016/S0022-0248(96)01022-6
- JOHANNA JANSSEN ET AL: "Low-Temperature Ohmic Contacts to n -ZnSe for all-Electrical Quantum Devices", ACS APPLIED ELECTRONIC MATERIALS, vol. 2, no. 4, 2 March 2020 (2020-03-02), pages 898 - 905, XP055708131, ISSN: 2637-6113, DOI: 10.1021/acsaelm.9b00824

## Beschreibung

Die Erfindung betrifft ein Verfahren für ein Herstellen eines ohmschen Kontakts bei einem elektronischen Bauelement. Die Erfindung betrifft ein elektronisches Bauelement mit einem ohmschen Kontakt für einen vergrabenen Halbleiter.

Ein ohmscher Kontakt ist ein Übergang zwischen einem Metall und einem Halbleiter mit einem kleinen elektrischen Widerstand.

Ein vergrabener Halbleiter ist ein Halbleiter, der sich im Inneren eines elektronischen Bauelements befindet. In der Regel handelt es sich um eine Schicht, die aus dem Halbleiter besteht und die sich zwischen zwei anderen Schichten befindet.

Ein lokaler ohmscher Kontakt für den vergrabenen Halbleiter ist ein aus Metall bestehender elektrischer Leiter oder ein Halbleiter des ohmschen Kontakts, der durch ein Loch des elektronischen Bauelements hindurchgeführt ist und den vergrabenen Halbleiter kontaktiert.

Um ein elektronisches Bauelement herzustellen, können ein oder mehrere Schichten auf einem Substrat aufgebracht werden. Die ein oder mehreren Schichten können aus Halbleitern bestehen. Ein oder mehrere dieser aufgebrachten Halbleiterschichten können aus dotierten Halbleitern bestehen und zwar insbesondere aus n-dotierten Halbleitern. Halbleiter können beispielsweise mit Chlor oder lod dotiert werden. Eine Dotierung mit Fluor ist ebenfalls möglich, aber grundsätzlich weniger gut geeignet im Vergleich zu Chlor und lod. Eine p-Dotierung ist auch möglich, aber in vielen Fällen weniger gut geeignet. Auf die auf dem Substrat aufgebrachten ein oder mehreren Halbleiterschichten kann eine elektrisch isolierende Deckschicht aufgebracht sein. Die ein oder mehreren Halbleiterschichten sind dann vergrabene Halbleiterschichten im Sinne der vorliegenden Erfindung. Um einen ohmschen Kontakt für eine vergrabene Halbleiterschicht herzustellen, kann ein Loch geschaffen werden, welches durch die Deckschicht zu der vergrabenen Halbleiterschicht hinführt. Das Loch kann durch Ätzen hergestellt werden. Im Anschluss an die Schaffung eines Loches kann dieses mit einem Metall gefüllt werden, um so einen lokalen ohmschen Kontakt zu schaffen, der oberhalb der Deckschicht elektrisch kontaktiert werden kann. Es ist so beispielsweise möglich, nachträglich ein elektronisches Bauelement mit zusätzlichen Gate-Elektroden zu bestücken, die für unipolare Bauelemente wie Feldeffekttransistor oder Elektronen-Spin-Qubit benötigt werden.

Bei elektronischen Bauelementen, die Substrate bzw. Schichten aus GaAs und AlGaAs oder aus Si und SiGe umfassen, können Metalle bei hohen Temperaturen thermisch in ein geschaffenes Loch einer Deckschicht einlegiert werden, um einen vergrabenen Halbleiter zu kontaktieren und einen lokalen ohmschen Kontakt zu schaffen. Es können vor dem Einlegieren eines Metalls durch lonenimplantation zusätzliche Dotierstoffe lokal eingebracht werden, um geeignet gute ohmsche Kontakte zu schaffen.

Die bekannten Verfahren zur Herstellung eines lokalen ohmschen Kontaktes sind nicht für alle Verbindungshalbleiter geeignet. So verträgt beispielsweise der II-VI-Verbindungshalbleiter ZnSe keine hohen Temperaturen, die für ein effizientes Einlegieren eines Metalls erforderlich ist. Ionenimplantation kann die Kristallstruktur von solchen Verbindungshalbleitern stark schädigen, wodurch die Leitfähigkeit stark reduziert wird. Die Herstellung eines Übergangs zwischen einem Metall und einem Halbleiter mit einem kleinen elektrischen Widerstand ist auf diese Weise dann nicht möglich. Das Problem tritt vor allem bei II-VI-Verbindungshalbleitern auf. Es können aber auch III-V-Verbindungshalbleiter von dem Problem betroffen sein.

Es kann von Interesse sein, elektronische Bauelemente bei tiefen Temperaturen betreiben zu können. Dies kann beispielsweise für Elektronen-Spin-Qubits eines Quantencomputers erforderlich sein.

Aus der US 2018/096885 A1 sind III-V-Verbindungshalbleiter-Feldeffekttransistoren bekannt. Außerdem wird ein Verfahren zum Bilden einer Halbleiterstruktur offenbart. Das Verfahren umfasst zunächst das Bilden von Source-/Drain-Bereichen auf gegenüberliegenden Seiten einer Gate-Struktur, die sich auf einer Verbindungshalbleiter-Kanalschicht befindet. Anschließend werden Source-/Drain-Kontaktöffnungen gebildet. Jede der Source/Drain-Kontaktöffnungen legt einen Teil einer der Source/Drain-Kontaktregionen frei. Als nächstes werden Metall-Halbleiter-Legierungsbereiche innerhalb der Source/Drain-Kontaktöffnungen gebildet.

Ein Verbindungshalbleiterbauelement der Gruppe II-VI und ein Verfahren zu seiner Herstellung sind aus der EP 0 674 347 A1 bekannt. Das Verfahren umfasst das Bilden einer Halbleiterschicht auf einem Halbleitersubstrat, das Bilden einer Zwischenschicht auf der Halbleiterschicht und das anschließende Bilden einer Elektrodenschicht auf der Zwischenschicht.

Die EP 1150360 A2 offenbart ein Verfahren zur Herstellung eines Verbindungshalbleiterbauelements mit einer ohmschen Elektrode mit niedrigem Kontaktpotential und eine Vorrichtung zur Herstellung eines Verbindungshalbleiterbauelements. Das Verfahren umfasst Substratreinigungsschritte.

Es ist Aufgabe der Erfindung, einen ohmschen Kontakt bei einem elektronischen Bauelement herstellen zu können und zwar insbesondere einen lokalen ohmschen Kontakt für vergrabene III-V-Verbindungshalbleiter oder II-VI-Verbindungshalbleiter eines elektronischen Bauelements. Dies soll vorzugsweise vor allem auch für solche II-VI-Verbindungshalbleiter möglich sein, die mit Chlor dotiert werden können. Der ohmsche Kontakt soll vorzugsweise auch ein Betreiben des zugehörigen elektronischen Bauelements bei tiefen Temperaturen ermöglichen.

Die Aufgabe der Erfindung wird durch ein Verfahren mit den Merkmalen des ersten Anspruchs und ein elektronisches Bauelement mit den Merkmalen des Nebenanspruchs gelöst. Vorteilhafte Ausgestaltungen ergeben sich aus den abhängigen Ansprüchen.

Zur Lösung der Aufgabe wird ein Verfahren zur Herstellung eines ohmschen Kontakts für ein elektronisches Bauteil vorgesehen. Um das elektronische Bauteil herzustellen, wird eine aus einem Halbleiter bestehende Schicht, also eine Halbleiterschicht, auf einem Substrat mittelbar oder unmittelbar aufgebracht. Ist die Halbleiterschicht unmittelbar auf das Substrat aufgebracht worden, so gibt es keine weitere Schicht zwischen der Halbleiterschicht und dem Substrat. Ist die Halbleiterschicht mittelbar auf das Substrat aufgebracht worden, so gibt es ein oder mehrere Schichten zwischen dem Substrat und der Halbleiterschicht.

Eine zu kontaktierende Oberfläche des Halbleiters wird nasschemisch geätzt. Die nasschemisch geätzte Oberfläche wird mit Radikalen gespült. Die mit Radikalen gespülte Oberfläche wird mit einem Metalldampf bearbeitet, wobei der Metalldampf ein Metall enthält, welches auch der Halbleiter aufweist. Auf der mit Radikalen gespülten Oberfläche wird ein elektrischer Leiter oder ein Halbleiter aufgebracht. Es ist auf diese Weise möglich, eine Verbindung zu einem Halbleiter herzustellen, der durch übliche Herstellungsverfahren leicht derart beschädigt werden kann, dass die Schaffung eines Übergangs mit einem kleinen elektrischen Widerstand nicht möglich ist. Es hat sich überraschend herausgestellt, dass solche Probleme durch das chemische Ätzen und das anschließende Spülen mit Radikalen gelöst werden können und zwar auch dann, wenn zuvor die Oberfläche in schädlicher Weise bearbeitet wurde wie zum Beispiel durch lonenätzen.

Ein Radikal ist ein Atom oder ein Molekül mit mindestens einem ungepaarten Valenzelektron. Bewährt hat sich ein Spülen mit Wasserstoffradikalen. Diese haben sich als geeignet reaktionsfreudig erwiesen.

Das nasschemische Ätzen und ein nachfolgendes Spülen mit Radikalen haben sich als entscheidende Schritte herausgestellt, um empfindliche II-VI- sowie III-V-Verbindungshalbleiter dennoch so kontaktieren zu können, dass nahezu perfekt lineare Strom - Spannung - Kennlinien und extrem niedrige Kontaktwiderstände bei Raumtemperatur und bei sehr tiefen Temperaturen erzielt werden können.

Vorzugsweise wird unter Ausschluss von Sauerstoff gespült. Vorzugsweise wird in einem Ultrahochvakuum und damit auch unter Ausschluss von Sauerstoff gespült, um ein weiter verbessertes Ergebnis zu erhalten. Diese Ausgestaltung ist vor allem für Verbindungshalbleiter von Vorteil, die an Luft schnell oxidieren können. ZnSe ist ein Beispiel für einen Verbindungshalbleiter, der an Luft schnell oxidieren kann. Durch Oxidation kann sich eine elektrisch nichtleitende oberflächliche Oxidschicht bilden, die eine Barriere für einen Stromtransport bildet. Ein Übergang mit einem kleinen elektrischen Widerstand kann dadurch verhindert werden.

Das Ergebnis kann weiter verbessert werden, indem bei einer erhöhten Temperatur von zum Beispiel 100°C bis 200°C gespült wird.

Das Spülen erfolgt vorzugsweise mehrere Minuten lang, so zum Beispiel 2-10 Minuten lang, um zu gewünschten Ergebnissen zu gelangen.

Beim nasschemischen Ätzen werden chemische Bindungen des zu bearbeitenden Materials durch Ätzmedien aufgebrochen und in lösliche Bestandteile überführt. Als Ätzmedien kommen regelmäßig K₂Cr₂O₇ + HBr + H₂O oder NH₃ + H₂O₂ + H₂O oder K₂Cr₂O₇ + H₂SO₄ + H₂O in Betracht.

Vorzugsweise wird einige Sekunden lang nasschemisch geätzt, so zum Beispiel 2-10 Sekunden lang, um den Verbindungshalbleiter in geeigneter Weise kontaktieren zu können.

Der Halbleiter, der durch nasschemisches Ätzen und anschließendem Spülen mit Radikalen für die Herstellung eines ohmschen Kontakts vorbereitet wird, kann ein II-VI-Verbindungshalbleiter oder ein III-V-Verbindungshalbleiter sein. Von den Vorteilen des Verfahrens profitieren vor allem II-VI-Verbindungshalbleiter, die mit Chlor dotiert werden können. Beispiele für solche II-VI-Verbindungshalbleiter sind (Zn,Mg)Se, (Zn,Cd)Se, (Zn,Mg)SSe, (ZnCd)SSe, ZnSe,CdSe oder ZnSSe.

Das Metall des Verbindungshalbleiters ist vorzugsweise ausgewählt aus Zink (Zn), Cadmium (Cd), Magnesium (Mg) und/oder Beryllium (Be). Das Nichtmetall des Verbindungshalbleiters ist vorzugsweise ausgewählt aus Selen (Se) und/oder Schwefel (S).

Um einen ohmschen Kontakt für einen vergrabenen Halbleiter herzustellen, kann ein Herstellungsverfahren die folgenden Schritte umfassen:
- Aufbringen von ein oder mehreren Halbleiterschichten auf ein Substrat;
- Aufbringen einer elektrisch nicht leitenden Deckschicht auf die ein oder mehreren aufgebrachten Halbleiterschichten, wobei die Deckschicht aus einem elektrisch nicht leitenden Dielektrikum bestehen kann;
- Schaffen eines Loches durch die Deckschicht hindurch zu einer Halbleiterschicht;
- diese durch das Loch hindurch erreichbare Oberfläche der Halbleiterschicht wird wie zuvor beschrieben nasschemisch geätzt,
- diese nasschemisch geätzte Oberfläche wird wie zuvor beschrieben mit Radikalen gespült,
- auf dieser mit den Radikalen gespülten Oberfläche wird ein dotierter Halbleiter aufgebracht und
- auf den aufgebrachten dotierten Halbleiter wird ein Metall, beispielsweise Aluminium, aufgebracht.

Ein so hergestelltes elektronisches Bauteil kann im Anschluss daran beispielsweise mit einer Gate-Elektrode bestückt werden.

Das in der Deckschicht geschaffene Loch, welches durch die Deckschicht hindurchführt, kann mit dem dotierten Halbleiter teilweise oder vollständig aufgefüllt worden sein. Das in der Deckschicht geschaffene Loch kann durch ein oder mehrere weitere Schichten unterhalb der Deckschicht hindurch geführt sein, um zu der gewünschten Halbleiterschicht zu gelangen. Ein oder mehrere der weiteren Schichten können Halbleiterschichten sein, also aus einem Halbleiter bestehen.

Es können eine Mehrzahl von Löchern in einer Deckschicht geschaffen werden, um eine Mehrzahl von lokalen ohmschen Kontakten herzustellen.

Das Auffüllen der Löcher mit einem dotierten Halbleiter geschieht vorzugsweise durch Molekularstrahlepitaxie. Hierdurch wird ein selektives Wachstum möglich. Das Wachstum kann so auf den Bereich von Löchern beschränkt werden. Ein derartiges Aufbringen mittels Molekularstrahlepitaxie ist unter der Bezeichnung Regrowth-Prozess bekannt. Eine Herstellung wird durch einen solchen Prozess vereinfacht. Ein zusätzlicher Schritt, nämlich das Wegätzen von dotiertem Halbleiter zwischen einer Mehrzahl von Löchern entfällt. Dies schließt aber nicht aus, dass in einer Ausgestaltung der Erfindung eine später aufgebrachte Metallschicht zwischen Löchern bzw. zwischen hergestellten ohmschen Kontakten weggeätzt wird. Vorteilhaft wird eine später aufgebrachte Metallschicht zwischen Löchern bzw. zwischen hergestellten ohmschen Kontakten so weggeätzt, dass durch diesen Schritt dann auch ein oder mehrere zusätzliche Gate-Elektroden unabhängig von den ohmschen Kontakten generiert werden.

Für die Herstellung eines elektronischen Bauteils, welches im fertig hergestellten Zustand ein unipolares Bauteil sein kann und welches auch bei tiefen Temperaturen eingesetzt werden kann, können ein oder mehreren Halbleiterschichten auf dem Substrat in einem Ultrahochvakuum aufgebracht werden. Im Anschluss daran kann die Deckschicht auf die ein oder mehreren aufgebrachten Halbleiterschichten in dem Ultrahochvakuum aufgebracht werden. Während des Beschichtens werden Oberflächen von Schichten bei dieser Ausführungsform nicht der Atmosphäre ausgesetzt und folglich auch nicht die Oberfläche, auf die die Deckschicht aufgebracht wird.

Benachbarte Halbleiterschichten bestehen aus unterschiedlichen Halbleitermaterialien und/oder sind zumindest unterschiedlich dotiert.

Es kann also beispielsweise eine erste Halbleiterschicht auf dem Substrat aufgebracht werden. Im Anschluss daran kann eine zweite Halbleiterschicht auf der ersten Halbleiterschicht aufgebracht werden. Im Anschluss daran kann eine dritte Halbleiterschicht auf der zweiten Halbleiterschicht aufgebracht werden. Im Anschluss daran kann eine Deckschicht auf der dritten Halbleiterschicht aufgebracht werden. Es können aber auch mehr als drei Halbleiterschichten aufgebracht werden, bevor eine Deckschicht aufgebracht wird.

Die erste und/oder die dritte aufgebrachte Halbleiterschicht können aus (Zn,Mg)Se, (Zn,Cd)Se, Zn(S,Se) oder (Zn,Mg)(S,Se) bestehen. Die zweite Schicht kann aus ZnSe oder CdSe bestehen. Diese Materialien sind besonders geeignet, um ein unipolares Bauteil herstellen zu können, dass auch bei tiefen Temperaturen eingesetzt werden kann, um als Qubits bei einem Quantencomputer dienen zu können. Die zweite Schicht kann als dotierte Schicht hergestellt worden sein. Dies ist aber nicht erforderlich.

Die Deckschicht kann aus einer Oxidkeramik bestehen. Die Deckschicht besteht beispielsweise aus Aluminiumoxid, Siliziumoxid oder Hafniumoxid. Die Deckschicht kann aber auch aus einem anderen Material wie zum Beispiel Siliziumnitrid bestehen. Die genannten Materialien können als optimales Gate-Dielektrikum dienen um unipolare Bauelemente herzustellen wie zum Beispiel 2D- oder 3D- Feldeffekttransistoren oder elektrostatisch definierte Elektronen-Spin-Qubits. Die Erfindung betrifft daher auch so beschaffene unipolare Bauelemente.

Allgemein eignet sich ein elektrisch nichtleitendes Dielektrikum als Material für die Deckschicht, um unipolare Bauelemente herzustellen.

Das Substrat kann aus einem Halbleiter bestehen. Das Substrat kann aus einem III-V-Halbleiter oder aus einem II-VI-Verbindungshalbleiter bestehen, um II-VI-Halbleiterschichten geeignet auf dem Substrat herstellen zu können. Das Substrat kann daher aus GaAs, ZnSe, (In,Ga)As, InAs, (In,Ga)P, (In,Ga,AI)P, InAs oder InP bestehen.

Ein durch die Deckschicht hindurchführendes Loch kann durch nasschemisches Ätzen insbesondere mit HF, geschaffen werden. Alternativ kann das Loch durch reaktives lonenätzen, insbesondere mit CHF₃ + O₂, geschaffen werden.

Soll das Loch in darunter liegende Schichten fortgesetzt werden, so kann dies durch reaktives lonenätzen geschehen. Dies kann regelmäßig mithilfe Cl₂+Ar, Cl₂+BCl₃ oder CH₄+H₂+Ar geschehen, so zum Beispiel im Fall von Verbindungshalbleitern, die aus (Zn,Mg)Se, Zn(S,Se), CdSe oder ZnSe bestehen.

Trockenätzprozesse können zwar die Kristallstruktur bei Verbindungshalbleitern nahe der Oberfläche stark schädigen. Durch ein sich daran anschließendes chemisches Nassätzen und einem nachfolgenden Spülen mit Radikalen können resultierende Probleme jedoch behoben werden, sodass es dennoch möglich ist, Übergänge mit kleinen elektrischen Widerständen herzustellen. Ein Spülen erfolgt insbesondere dann unter Ausschluss von Sauerstoff, wenn der entsprechende Halbleiter leicht oxidieren kann.

Um ein Loch durch die Deckschicht hindurchführendes Loch durch Ätzen herzustellen, kann auf der Deckschicht eine Ätzmaske aufgebracht werden. Die Deckschicht kann aus einem Fotolack bestehen, wobei der Lack mit einem Loch versehen ist. Der Lack mit einem Loch kann durch optische Lithographie hergestellt worden sein.

Nachdem ein durch die Deckschicht hindurchführendes Loch durch Ätzen bis in die gewünschte Tiefe hergestellt wurde, kann wie zuvor beschrieben die zu kontaktierende Oberfläche des aufgebrachten Halbleiters nasschemisch geätzt werden.

Nach diesem abschließenden Ätzen kann die Ätzmaske entfernt werden. Es ist aus technischen Gründen zweckmäßig nun zu reinigen, so zum Beispiel mit einem Lösungsmittel wie Isopropanol. Insbesondere sollte dann die zu kontaktierende Oberfläche des aufgebrachten Halbleiters gereinigt werden, also die Halbleiterschicht, die für den ohmschen Kontakt vorgesehen ist.

Um das gewünschte technische Ergebnis weiter zu verbessern, ist es von Vorteil, Verfahren nach dem Ätzen und vorzugsweise auch nach dem Reinigen das Bauelement thermisch zu behandeln. Dies kann bei einer Temperatur geschehen, die zwischen 100°C und 200°C liegen kann. Die thermische Behandlung kann mehrere Minuten lang dauern, so zum Beispiel wenigstens 15 Minuten lang. Spätestens nach 60 Minuten kann die thermische Behandlung abgeschlossen werden, da dann in der Regel kein vorteilhafter Effekt mehr erzielt werden kann. Es genügt daher beispielsweise eine Behandlungszeit von etwa 30 Minuten.

Um ein weiter verbessertes technisches Ergebnis zu erhalten, erfolgt die thermische Behandlung vorzugsweise in einem Ultrahochvakuum. Es können so nachteilhafte Umgebungseinflüsse geeignet vermieden werden.

Im Anschluss an die thermische Behandlung kann mit Radikalen, insbesondere mit Wasserstoffradikalen, gespült werden und zwar vorzugsweise mehrere Minuten lang. Dies geschieht vorzugsweise in einem Ultrahochvakuum, besonders bevorzugt in dem Ultrahochvakuum, welches für die thermische Behandlung bereitgestellt worden ist. Es wird also insbesondere vermieden, dass das herzustellende Bauteil nach der thermischen Behandlung und vor dem Spülen mit Radikalen mit der Atmosphäre in Berührung kommt.

Nach dem Spülen mit Radikalen wird die zu kontaktierende Oberfläche der Halbleiterschicht mit einem Metalldampf bearbeitet. Der Metalldampf enthält ein Metall, welches auch der Halbleiter aufweist. Besteht der Halbleiter also beispielsweise aus ZnSe, so enthält der Metalldampf als Metall Zink. Der Metalldampf wird daher im Fall von ZnSe durch eine Zinkquelle erzeugt. Durch eine solche Metallquelle wird Metall thermisch verdampft. Eventuell vorhandene Metallfehlstellen können so aufgefüllt werden, was zu einem weiter verbesserten gewünschten technischen Ergebnis führen kann. Die Bearbeitung mit dem Metalldampf geschieht vorzugsweise in einem Ultrahochvakuum, vorzugsweise in dem Ultrahochvakuum, welches bereits für vorherige Schritte bereitgestellt wurde. Nach wie vor wird dann ein Kontakt zur Atmosphäre verhindert.

Abschließend kann das Loch mit einem Halbleiter ganz oder teilweise gefüllt werden und zwar grundsätzlich mit einem Halbleiter, der mit dem Halbleiter übereinstimmt, der kontaktiert werden soll. Soll also beispielsweise eine aus ZnSe bestehende Schicht kontaktiert werden, so wird vorzugsweise das Loch mit ZnSe ganz oder teilweise gefüllt. Allerdings können sich die beiden Halbleiter durch ihre Dotierung unterscheiden. So kann das Loch mit n-dotiertem ZnSe ganz oder teilweise gefüllt werden, um eine Schicht zu kontaktieren, die aus undotiertem ZnSe hergestellt worden ist.

Das Loch wird vorzugsweise bei einer für ein Wachstum besonders geeigneten Temperatur von zum Beispiel 200-400 °C mit dem Halbleiter aufgefüllt. Geeignet ist beispielsweise eine Temperatur von 300 °C für ZnSe. Das Auffüllen des Loches geschieht in einem Ultrahochvakuum, vorzugsweise auch weiterhin in dem Ultrahochvakuum, welches bereits für vorherige Schritte bereitgestellt wurde, um einen Kontakt zur Atmosphäre auch weiterhin zu verhindern.

Ist das Loch ganz oder teilweise mit einem Halbleiter gefüllt worden, so wird abschließend Metall auf diesem Halbleiter aufgebracht. Dies geschieht beispielsweise mithilfe einer Aufdampfanlage für Metall. Dies geschieht wiederum vorzugsweise unverändert in dem vorgenannten Ultrahochvakuum, sodass unverändert ein Kontakt zur Atmosphäre verhindert wird. Der beispielsweise durch Regrowth hergestellte Halbleiter kann daher nicht oxidieren, bevor Metall aufgetragen wurde.

Als Metall eignet sich insbesondere Aluminium. Gut geeignet sind außerdem Titan oder Magnesium.

Damit die zuletzt genannten Schritte in situ in einem Ultrahochvakuum durchgeführt werden können, sind die dafür benötigten Anlagen untereinander durch das Ultrahochvakuum gekoppelt. Es gibt also eine Kammer, in der ein Ultrahochvakuum erzeugt werden kann. Diese Kammer umfasst eine Molekularstrahlepitaxie - Anlage für Verbindungshalbleiter, eine Aufdampfanlage für Metall, so zum Beispiel für Aluminium, eine Atomic Layer Depositionsanlage sowie eine Radikalquelle, beispielsweise für Wasserstoffradikale.

Vergleichsversuche haben gezeigt, dass auf diese Weise im Fall von empfindlichen Verbindungshalbleitern ein ohmscher Kontakt mit erheblich besseren Eigenschaften im Vergleich zum bekannten Stand der Technik bereitgestellt werden kann.

Die Erfindung betrifft auch ein nach dem Verfahren herstellbares elektronisches Bauelement mit mehreren Halbleiterschichten auf einem Substrat, einer Deckschicht auf den ein oder mehreren auf dem Substrat aufgebrachten Halbleiterschichten, wobei die Deckschicht aus einem elektrisch nicht leitenden Dielektrikum besteht. Benachbarte Halbleiterschichten bestehen aus unterschiedlichen II-VI-Halbleitern, so dass ein Heteroübergang vorliegt. Aufgrund eines geschaffenen Loches gibt es einem Zugang, der durch die Deckschicht hindurch zu einer Halbleiterschicht führt und in diese hineinreicht. Der Zugang ist zumindest teilweise mit einem II-VI-Halbleiter gefüllt. Auf dem II-VI-Halbleiter ist ein metallischer Kontakt aufgebracht. Dieser füllt den Zugang zumindest vollständig aus, so dass dieser zumindest bis zur Außenseite der Deckschicht reicht. In der Regel steht der metallische Kontakt gegenüber der Deckschicht nach außen vor. Der metallische Kontakt besteht insbesondere aus Aluminium.

Die erste und/oder die dritte aufgebrachte Halbleiterschicht besteht vorzugsweise aus (Zn,Mg)Se, Zn(S,Se), (Zn,Cd)Se oder (Zn,Mg)(S,Se). Die zweite Halbleiterschicht besteht insbesondere aus ZnSe oder CdSe. Die Deckschicht besteht vorzugsweise aus Aluminiumoxid, Siliziumoxid, Hafniumoxid oder Siliziumnitrid. Das Substrat kann aus GaAs, ZnSe, AlAs, InAs, GaP, AIP oder InP oder aus Mischformen wie (In,Ga)As oder (In,Al)GaP bestehen.

Die Erfindung betrifft weiter ein unipolares Bauelement, welches wie zuvor beschrieben aufgebaut sein kann. Das unipolare Bauelement kann ein Feldeffekttransistor oder ein Hochmobilitätstransistor sein. Es kann sich um ein Elektronenspin-Qubit-Bauelement handeln.

Nachfolgend wird die Erfindung anhand eines Beispiels näher erläutert.

Es zeigen:
- Figur 1:: Schichtaufbau mit einer ZnSe Schicht;
- Figur 2:: Schichtaufbau mit Loch;
- Figur 3:: Schichtaufbau mit teilweise mit Halbleiter gefülltem Loch;
- Figur 4:: Schichtaufbau mit aufgebrachtem Aluminium;
- Figur 5:: Schichtaufbau mit fertig gestelltem, lokalem ohmschen Kontakt;
- Figur 6:: gemessene Strom-Spannungs-Kennlinien;
- Figur 7: weiterer Aufbau für ein elektronisches Bauelement mit vergrabenen Halbleiterschichten und lokalem ohmschen Kontakt.

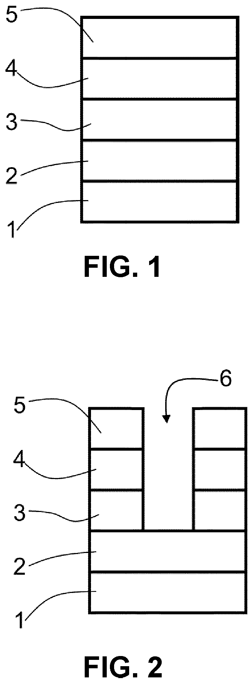

Die Figur 1 zeigt ein Substrat 1 aus Galliumarsenid, auf das in einem Ultrahochvakuum eine vergrabene erste Halbleiterschicht 2 aus (Zn,Mg)Se aufgetragen wurde. Auf der ersten Halbleiterschicht 2 ist in dem Ultrahochvakuum in situ eine vergrabene zweite Halbleiterschicht 3 aus ZnSe aufgetragen worden. Auf der zweiten Halbleiterschicht 3 ist in dem Ultrahochvakuum in situ eine vergrabene dritte Halbleiterschicht 4 aus (Zn,Mg)Se aufgetragen worden. Auf der dritten Halbleiterschicht 4 ist in dem Ultrahochvakuum in situ eine Deckschicht 5 aus Al₂O₃ aufgetragen worden. Das Auftragen geschieht beispielsweise durch Atomic Layer Deposition. Die Schichten können mehrere 10 Nanometer dick sein, so zum Beispiel 20 nm dick sein.

In situ meint, dass der in der Figur 1 hergestellte Aufbau während seiner Herstellung nicht aus dem Ultrahochvakuum entfernt wurde, so dass keine nachteilhaften Oxidationseffekte auftreten konnten.

Nach der Abscheidung der Al₂O₃ - Schicht wird der Aufbau aus dem Ultrahochvakuum entfernt. Mittels herkömmlicher optischer Lithographie wird eine Netzmaske mit Löchern in einem zuvor aufgebrachten Fotolack definiert, in denen später per Regrowth die ohmschen Kontakte entstehen werden. An den Positionen der Löcher wird zunächst die Al₂O₃ - Schicht 5 entweder nasschemisch mit HF oder per reaktiven lonenätzen mit CHF₃ + O₂ geöffnet. Danach werden die darunterliegenden (Zn,Mg)Se und ZnSe Schichten 4 und 3 mittels reaktivem lonenätzen mit Cl₂ + Ar geöffnet. Es wird also heruntergeätzt, wie dies in der Figur 2 gezeigt wird, um so ein Loch 6 zu schaffen. Durch dieses Loch 6 hindurch kann die Halbleiterschicht 3 kontaktiert werden.

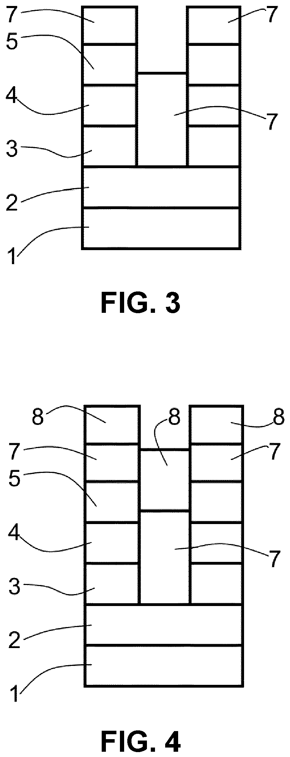

Nach dem reaktiven lonenätzen wird der entstandene Strahlenschaden durch nasschemisches Nachätzen für ca. 5 Sekunden mit einer Lösung aus K₂Cr₂O₇ + HBr + H₂O entfernt. Dann wird der Fotolack entfernt und die geätzte ZnSe - Halbleiterschicht 3 mit Isopropanol gereinigt und für den Regrowth Prozess wieder in das Ultrahochvakuum eingeschleust. Danach wird der Aufbau im Ultrahochvakuum für 30 Minuten auf 150 °C aufgeheizt und anschließend 5 Minuten mit Wasserstoffradikalen gespült. Auf diese Weise werden chemische Rückstände des Ätz- und Reinigungsprozesses sowie etwaige Oxidreste auf der Oberfläche entfernt. Danach wird die geätzte Schicht unter Zinkfluss langsam auf die für den Regrowth Prozess geeignete Wachstumstemperatur von 300 °C aufgeheizt. Dieses dient dazu, etwaige verbleibende Zinkfehlstellen in der Nähe der geätzten Oberfläche aufzufüllen. Danach erfolgt das Wachstum einer Chlor dotierten ZnSe Schicht 7 mittels Molekularstrahlepitaxie (MBE) unter üblichen Wachstumsparametern. Dies wird in der Figur 3 gezeigt. Die Schicht 7 sollte mindestens so dick sein, dass diese das Loch bis in die Al₂O₃ Schicht 5 auffüllt. Andernfalls würde das Metall 8 auf der Schicht 7 die Schicht 4 und damit den Halbleiter (Zn,Mg)Se seitlich kontaktieren. Das könnte unvorteilhaft sein und sollte daher vermieden werden.

Anschließend wird die neu gewachsene dotierte ZnSe Schicht 7 in situ mit Aluminium 8 als ohmsches Kontaktmaterial beschichtet, was in der Figur 4 gezeigt wird. Die in situ abgeschiedene Aluminiumsschicht 8 verhindert die Bildung eines Oxids zwischen der Chlor dotierten ZnSe - Schicht 7 und der Aluminiumschicht 8, sodass ein ungehinderter Stromtransport durch das Aluminium - ZnSe Interface stattfinden kann.

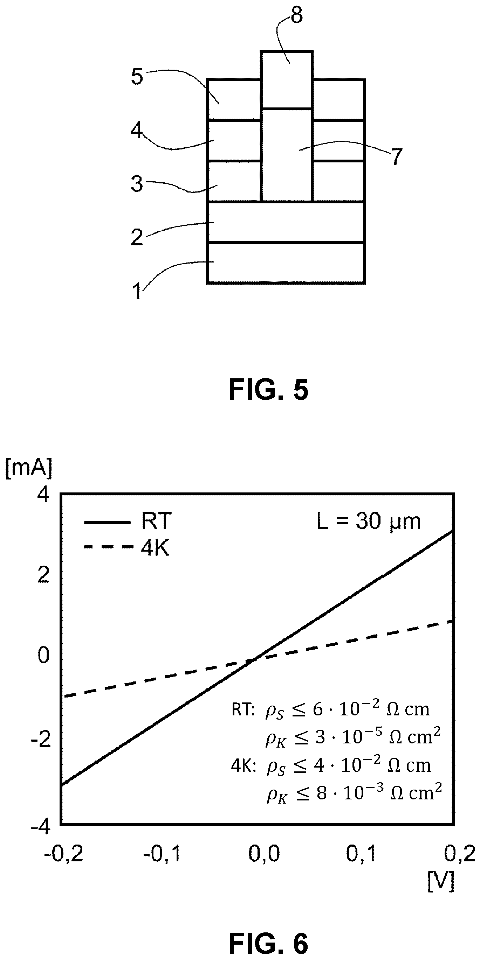

In einem letzten Schritt wird dann mittels optischer Lithographie und nachfolgender nasschemischer Ätzung das überschüssige Aluminium und ZnSe zwischen den eigentlichen lokalen Kontakten entfernt, bis der in der Figur 5 gezeigte Aufbau erreicht ist.

Die Schichtdicken in der Figur 5 sind nur schematisch dargestellt. So können die beiden Halbleiterschichten 2 und 4 dicker sein als die Halbleiterschicht 3. Die Deckschicht 5 kann dünner sein als die Halbleiterschicht 3. Vorteilhafterweise ist die Halbleiterschicht 7 mindestens so dick, dass sie in die dielektrische Schicht 5 hineinreicht.

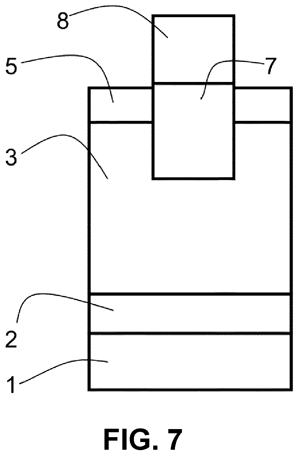

Auf diese Weise lassen sich exzellente lokale ohmsche Kontakte mit minimalem Kontaktwiderstand und einer linearen Stromspannungskennlinie bei Raumtemperatur und Tieftemperatur realisieren. Figur 6 zeigt ein Diagramm mit entsprechend linearen Stromspannungskennlinien, die bei Raumtemperatur RT (durchgezogene Linie) und 4 K (gestrichelte Linie) gemessen wurden und zwar mit dem Aufbau, der in der Figur 7 gezeigt wird. Der Abstand zwischen zwei ohmschen Kontakten des Bauteils, die für die Messung verwendet wurden, betrug 30 µm. Aufgetragen ist der gemessene Strom in Milliampere gegen die angelegte Spannung in Volt. Neben der hervorragenden Linearität der Stromspannungskennlinien lassen sich aus der Messung der Kontaktwiderstand und der Schichtwiderstand des in Figur 7 gezeigten Bauelementes bestimmen. Bei Raumtemperatur ist der Kontaktwiderstand ρ_{K} ≤ 3×10⁻⁵ Ωcm² und der Schichtwiderstand ρₛ ≤ 6×10⁻² Ωcm, bei Tieftemperatur ist der Kontakwiderstand ρ_{K} ≤ 8×10⁻³ Ωcm² und der Schichtwiderstand ρₛ ≤ 4×10⁻² Ωcm

Das in der Figur 7 gezeigte Bauelement umfasst ein Substrat 1 aus Galliumarsenid. Auf dem Substrat befindet sich eine nicht dotierte, ca. 20 nm dicke ZnSe-Halbleiterschicht 2.Auf der ZnSe-Halbleiterschicht 2 befindet sich eine ca. 800 nm dicke, mit Chlor dotierte ZnSe-Halbleiterschicht 3. Auf der Halbleiterschicht 3 befindet sich eine ca. 20nm dicke dielektrische Schicht 5 aus Al₂O₃. Ein zu der Halbleiterschicht 2 mittels Loch geschaffener Zugang ist vollständig mit Chlor dotiertem ZnSe, also mit ZnSe:CI gefüllt worden. Auf dieser ZnSe:CI Füllung 7 ist Aluminium 8 mit einer Dicke von ca. 120 nm aufgebracht.

## Patentansprüche

1. Verfahren zur Herstellung eines ohmschen Kontakts für ein elektronisches Bauteil, wobei eine aus einem Halbleiter bestehende Schicht (3) auf einem Substrat (1) mittelbar oder unmittelbar aufgebracht wird wobei eine zu kontaktierende Oberfläche des aufgebrachten Halbleiters (3) nasschemisch geätzt wird, die nasschemisch geätzte Oberfläche mit Radikalen gespült wird, die mit Radikalen gespülte Oberfläche mit einem Metalldampf bearbeitet wird, wobei der Metalldampf ein Metall enthält, welches auch der Halbleiter aufweist, und auf der mit Radikalen gespülten Oberfläche ein elektrischer Leiter (8) oder ein Halbleiter (7) aufgebracht wird.

2. Verfahren nach dem vorhergehenden Anspruch, **dadurch gekennzeichnet, dass** mit Wasserstoffradikalen gespült wird.

3. Verfahren nach einem der vorhergehenden Ansprüche, **dadurch gekennzeichnet, dass** in einem Ultrahochvakuum gespült wird.

4. Verfahren nach einem der vorhergehenden Ansprüche, **dadurch gekennzeichnet, dass** bei einer Temperatur zwischen 100°C und 200°C gespült wird.

5. Verfahren nach einem der vorhergehenden Ansprüche, **dadurch gekennzeichnet, dass** mit K₂Cr₂O₇ + HBr + H₂O oder mit NH₃ + H₂O₂ + H₂O oder mit K₂Cr₂O₇ + H₂SO₄ + H₂O nasschemisch geätzt wird.

6. Verfahren nach einem der vorhergehenden Ansprüche, **dadurch gekennzeichnet, dass** 1 bis 20 Sekunden nasschemisch geätzt wird.

7. Verfahren nach einem der vorhergehenden Ansprüche, **dadurch gekennzeichnet, dass** der Halbleiter (3) ein II-VI-Halbleiter oder ein III-V-Halbleiter ist und insbesondere aus (Zn,Mg)Se, Zn(S,Se), ZnSe,, CdSe oder (Zn,Mg)(S,Se) besteht.

8. Verfahren nach einem der vorhergehenden Ansprüche, **dadurch gekennzeichnet, dass** das Metall des Halbleiters ausgewählt ist aus Zink (Zn), Cadmium (Cd), Magnesium (Mg) und/oder Beryllium (Be).

9. Verfahren nach einem der vorhergehenden Ansprüche, **dadurch gekennzeichnet, dass** das Nichtmetall des Halbleiters ausgewählt ist aus Selen (Se) und/oder Schwefel (S).

10. Verfahren nach einem der vorhergehenden Ansprüche, **dadurch gekennzeichnet, dass** der Halbleiter mit Chlor (CI) dotiert oder mit Chlor (Cl) dotierbar ist.

11. Elektronisches Bauelement mit ein oder mehreren Halbleiterschichten (2, 3, 4) auf einem Substrat (1), einer Deckschicht (5) auf den ein oder mehreren auf dem Substrat (1) aufgebrachten Halbleiterschichten (2, 3, 4), wobei die Deckschicht (5) aus einem elektrisch nicht leitenden Dielektrikum besteht, mit einem Zugang (6), der durch die Deckschicht hindurch zu einer Halbleiterschicht (3) führt und in diese hineinreicht, wobei benachbarte Halbleiterschichten (2, 3, 4) aus unterschiedlichen II-VI-Halbleitern bestehen, wobei der Zugang (6) zumindest teilweise mit einem dotierten II-VI-Halbleiter (7) gefüllt ist und auf dem dotierten II-VI-Halbleiter (7) ein metallischer Kontakt (8) aufgebracht ist, der bis zur Außenseite der Deckschicht (5) reicht oder gegenüber der Deckschicht (5) nach außen vorsteht.

12. Elektronisches Bauelement nach dem vorhergehenden Anspruch, **dadurch gekennzeichnet, dass** die erste und/oder die dritte aufgebrachte Halbleiterschicht (2, 4) aus (Zn,Mg)Se, (Zn,Mg)(S,Se), (Zn,Be)Se, Zn(S,Se) und/oder dass die zweite Halbleiterschicht (3) aus ZnSe besteht.

13. Elektronisches Bauelement nach einem der zwei vorhergehenden Ansprüche, **dadurch gekennzeichnet, dass** die Deckschicht (5) aus Aluminiumoxid, Siliziumoxid, Hafniumoxid oder Siliziumnitrid besteht.

14. Elektronisches Bauelement nach einem der drei vorhergehenden Ansprüche, **dadurch gekennzeichnet, dass** das Substrat (1) aus GaAs, ZnSe, (In,Ga)As, InAs, (In,Ga)P, (In,Ga,Al)P oder InP besteht.

15. Elektronisches Bauelement nach einem der vier vorhergehenden Ansprüche, **dadurch gekennzeichnet, dass** dieses ein unipolares Bauelement ist.

## Claims

1. Method for producing an ohmic contact for an electronic component, wherein a layer (3) consisting of a semiconductor is applied directly or indirectly to a substrate (1), wherein a surface of the applied semiconductor (3) to be contacted is wet-chemically etched, the wet-chemically etched surface is rinsed with radicals, the surface rinsed with radicals is processed with a metal vapor, wherein the metal vapor includes a metal which is also present in the semiconductor, and an electrical conductor (8) or a semiconductor (7) is applied to the surface rinsed with radicals.

2. Method according to the preceding claim, **characterized in that** rinsing is carried out with hydrogen radicals.

3. Method according to one of the preceding claims, **characterized in that** rinsing is carried out in an ultra-high vacuum.

4. Method according to one of the preceding claims, **characterized in that** rinsing is carried out at a temperature between 100°C and 200°C.

5. Method according to one of the preceding claims, **characterized in that** wet-chemical etching is carried out with K₂Cr₂O₇ + HBr + H₂O or with NH₃ + H₂O₂ + H₂O or with K₂Cr₂O₇ + H₂SO₄ + H₂O.

6. Method according to one of the preceding claims, **characterized in that** wet chemical etching is carried out for 1 to 20 seconds.

7. Method according to one of the preceding claims, **characterized in that** the semiconductor (3) is a II-VI semiconductor or a III-V semiconductor and consists in particular of (Zn,Mg)Se, Zn(S,Se), ZnSe, CdSe or (Zn,Mg)(S,Se).

8. Method according to one of the preceding claims, **characterized in that** the metal of the semiconductor is selected from zinc (Zn), cadmium (Cd), magnesium (Mg) and/or beryllium (Be).

9. Method according to one of the preceding claims, **characterized in that** the non-metal of the semiconductor is selected from selenium (Se) and/or sulphur (S).

10. Method according to one of the preceding claims, **characterized in that** the semiconductor is doped with chlorine (CI) or can be doped with chlorine (CI).

11. Electronic component having one or more semiconductor layers (2, 3, 4) on a substrate (1), a cover layer (5) on the one or more semiconductor layers (2, 3, 4) applied to the substrate (1), wherein the cover layer (5) consists of an electrically non-conductive dielectric, having an access (6) which leads through the cover layer to a semiconductor layer (3) and extends into the latter, wherein adjacent semiconductor layers (2, 3, 4) consist of different II-VI semiconductors, wherein the access (6) is at least partially filled with a doped II-VI semiconductor (7) and a metallic contact (8) is applied to the doped II-VI semiconductor (7), which contact extends to the outside of the cover layer (5) or projects outwards with respect to the cover layer (5).

12. Electronic component according to the preceding claim, **characterized in that** the first and/or the third applied semiconductor layer (2, 4) consists of (Zn,Mg)Se, (Zn,Mg)(S,Se), (Zn,Be)Se, Zn(S,Se) and/or **in that** the second semiconductor layer (3) consists of ZnSe.

13. Electronic component according to one of the two preceding claims, **characterized in that** the cover layer (5) consists of aluminium oxide, silicon oxide, hafnium oxide or silicon nitride.

14. Electronic component according to one of the three preceding claims, **characterized in that** the substrate (1) consists of GaAs, ZnSe, (In,Ga)As, InAs, (In,Ga)P, (In,Ga,AI)P or InP.

15. Electronic component according to one of the preceding claims, **characterized in that** it is a unipolar component.

## Revendications

1. Procédé de fabrication d'un contact ohmique pour un composant électronique, dans lequel une couche (3) constituée d'un semi-conducteur est déposée directement ou indirectement sur un substrat (1), dans lequel une surface à contacter du semi-conducteur (3) déposé est gravée chimiquement par voie humide, la surface gravée chimiquement par voie humide est rincée avec des radicaux, la surface rincée avec des radicaux est traitée avec une vapeur de métal, dans lequel la vapeur de métal contient un métal que le semi-conducteur présente également, et un conducteur électrique (8) ou un semi-conducteur (7) est déposé sur la surface rincée avec des radicaux.

2. Procédé selon la revendication précédente, **caractérisé en ce que** l'on rince avec des radicaux d'hydrogène.

3. Procédé selon l'une des revendications précédentes, **caractérisé en ce que** l'on rince dans un ultravide.

4. Procédé selon l'une des revendications précédentes, **caractérisé en ce que** l'on rince à une température comprise entre 100°C et 200°C.

5. Procédé selon l'une des revendications précédentes, **caractérisé en ce que** l'on grave chimiquement par voie humide avec du K₂Cr₂O₇ + HBr + H₂O ou avec du NH₃ + H₂O₂ + H₂O ou avec du K₂Cr₂O₇ + H₂SO₄ + H₂O.

6. Procédé selon l'une des revendications précédentes, **caractérisé en ce que** l'on grave chimiquement par voie humide pendant 1 à 20 secondes.

7. Procédé selon l'une des revendications précédentes, **caractérisé en ce que** le semi-conducteur (3) est un semi-conducteur II-VI ou un semi-conducteur III-V et est notamment constitué de (Zn,Mg)Se, Zn(S,Se), ZnSe, CdSe ou (Zn,Mg)(S5,Se).

8. Procédé selon l'une des revendications précédentes, **caractérisé en ce que** le métal du semi-conducteur est choisi parmi le zinc (Zn), le cadmium (Cd), le magnésium (Mg) et/ou le béryllium (Be).

9. Procédé selon l'une des revendications précédentes, **caractérisé en ce que** le non-métal du semi-conducteur est choisi parmi le sélénium (Se) et/ou le soufre (S).

10. Procédé selon l'une des revendications précédentes, **caractérisé en ce que** le semi-conducteur est dopé au chlore (CI) ou peut être dopé au chlore (Cl).

11. Composant électronique comprenant une ou plusieurs couches semi-conductrices (2, 3, 4) sur un substrat (1), une couche de recouvrement (5) sur les une ou plusieurs couches semi-conductrices (2, 3, 4) déposées sur le substrat (1), dans lequel la couche de recouvrement (5) est constituée d'un diélectrique non conducteur de l'électricité, avec un accès (6) qui mène à travers la couche de recouvrement à une couche semi-conductrice (3) et qui pénètre dans celle-ci, dans lequel des couches semi-conductrices voisines (2, 3, 4) sont constituées de semi-conducteurs II-VI différents, dans lequel l'accès (6) est rempli au moins partiellement d'un semi-conducteur II-VI dopé (7) et un contact métallique (8) est déposé sur le semi-conducteur II-VI dopé (7), qui s'étend jusqu'au côté extérieur de la couche de recouvrement (5) ou fait saillie vers l'extérieur par rapport à la couche de recouvrement (5).

12. Composant électronique selon la revendication précédente, **caractérisé en ce que** la première et/ou la troisième couche semi-conductrice (2, 4) déposée est constituée de (Zn,Mg)Se, (Zn,Mg)(S,Se), (Zn,Be)Se, Zn(S,Se) et/ou **en ce que** la deuxième couche semi-conductrice (3) est constituée de ZnSe.

13. Composant électronique selon l'une des deux revendications précédentes, **caractérisé en ce que** la couche de recouvrement (5) est constituée d'oxyde d'aluminium, d'oxyde de silicium, d'oxyde de hafnium ou de nitrure de silicium.

14. Composant électronique selon l'une des trois revendications précédentes, **caractérisé en ce que** le substrat (1) est constitué de GaAs, ZnSe, (In,Ga)As, InAs, (In,Ga)P, (In,Ga,AI)P ou InP.

15. Composant électronique selon l'une des quatre revendications précédentes, **caractérisé en ce qu'**il s'agit d'un composant unipolaire.
